# EUROPEAN PATENT APPLICATION

(11) **EP 4 808 338 A2**
(43) Date of publication of application: **16.09.2026**
(21) Application number: 26158292.8
(22) Date of filing: 12.02.2026
(51) Int. Cl.: H10P 74/00, H10P 74/20

(54) **BULK INCLUSION PREDICTION MODEL FOR WAFER CUTTING TECHNOLOGY**

(30) Priority: 20.02.2025 SE 2550159
(71) Applicant: STMicroelectronics International N.V., 1228 Plan-les-Ouates, Geneva (CH)
(72) Inventor: THÖRNBERG, Jimmy, 58333 LINKÖPING (SE)
(74) Representative: Studio Torta S.p.A.

(57) **Abstract**

A system and method reliably sort wafers as suitable or unsuitable for processing. A plurality of first test wafers are initially sliced from a semiconductor ingot. A first surface analysis process is performed on each of the first test wafers to generate first surface defect data. A plurality of second test wafers are formed from the first test wafers by bonding the first test wafers to respective substrates. A second surface analysis process is then performed on the second test wafers to generate second surface defect data. A wafer sorting model is generated from the first and second surface defect data. Subsequently, embodiments of the present disclosure utilize the model to sort wafers after performing the first surface analysis process on the wafers.

## Description

### Technical Field

This present disclosure is related to wafer processing, and, more particularly, to quality control of wafers.

### Description of the Related Art

Integrated circuits are utilized in a wide variety of electronic applications. Typically, integrated circuits are formed from semiconductor wafers. Each semiconductor wafer undergoes a large number of processing steps in order to form a plurality of identical integrated circuits. After wafer processing is complete, the wafers are diced to singulate individual integrated circuits.

The wafers are formed from semiconductor ingots. In particular, cylindrical semiconductor ingots are formed in a lengthy process. Individual wafers are then sliced from ingots. It is possible that during formation of the ingots, defects may propagate within the ingots. When the wafers are sliced from the ingots, the defects may be present in the wafers. In some cases, the presence of defects in a wafer can result in nonfunctioning integrated circuits after wafer processing. It can be difficult to determine which wafers are suitable for processing.

All of the subject matter discussed in the Background section is not necessarily prior art and should not be assumed to be prior art merely as a result of its discussion in the Background section. Along these lines, any recognition of problems in the prior art discussed in the Background section or associated with such subject matter should not be treated as prior art unless expressly stated to be prior art. Instead, the discussion of any subject matter in the Background section should be treated as part of the inventor's approach to the particular problem, which, in and of itself, may also be inventive.

### BRIEF SUMMARY

The present invention relates to methods and to a system as defined in the annexed claims.

In general, embodiments of the present disclosure provide a system and method for reliably determining which wafers are suitable for processing and which wafers should be discarded or repurposed due to the presence of defects. A plurality of first test wafers are initially sliced from a semiconductor ingot. A first surface analysis process is performed on each of the first test wafers to generate first surface defect data. A plurality of second test wafers are formed from the first test wafers by bonding the first test wafers to respective substrates. A second surface analysis process is then performed on the second test wafers to generate second surface defect data. Embodiments of the present disclosure generate, from the first and second surface defect data, a wafer sorting model based on the first surface defect data and the second surface defect data. Subsequently, embodiments of the present disclosure utilize the model to sort wafers after performing the first surface analysis process on the wafers.

In one exemplary embodiment, the second test wafers are formed by bonding the first test wafers to the substrates and then further slicing the first test wafers to reduce the thickness of the first test wafers. Accordingly, the second surface analysis process is performed on a second test wafer that includes a thin slice of a first test wafer. In one embodiment, a plurality of second test wafers is formed from each first test wafer.

In one exemplary embodiment, the model includes a surface defect threshold. After generation of the model, wafers are sorted by comparing a surface defect number for each wafer, based on the first surface analysis process, to the surface defect threshold. In one embodiment, after generation of the model, the second surface defect process is not performed. Wafers that are sorted as acceptable are bonded to substrates as described above in relation to the second test wafers. The wafers are then processed to form reliable integrated circuits.

### BRIEF DESCRIPTION OF THE SEVERAL VIEWS OF THE DRAWINGS

Figure 1A is an illustration of a semiconductor ingot, in accordance with one embodiment.
Figure 1B is an illustration of a plurality of first wafers sliced from the semiconductor ingot of Figure 1A, in accordance with one embodiment.
Figure 1C is a cross-sectional view of a first wafer, in accordance with one embodiment.
Figure 1D is a cross-sectional view of a second wafer prior to a thinning process, in accordance with one embodiment.
Figure 1E of a second wafer after a thinning process, in accordance with one embodiment.
Figure 2 is a functional flow diagram of a process for generating a wafer analysis model, in accordance with one embodiment.
Figure 3 is a graph of first surface defect data for a plurality of first test wafers, in accordance with one embodiment.
Figure 4 is a graph of second surface defect data for a plurality of second test wafers, in accordance with one embodiment.
Figure 5 is a graph of first surface defect data, including a defect threshold, for a plurality of wafers, in accordance with one embodiment.
Figure 6 is a functional flow diagram of a process for sorting wafers in accordance with one embodiment.
Figure 7 is a cross-sectional diagram of a fully processed wafer after a sorting process, in accordance with one embodiment.
Figure 8 is a flow diagram of a method for generating a wafer defect analysis model, in accordance with one embodiment.
Figure 9 is a flow diagram of a method for sorting wafers, in accordance with one embodiment.

### DETAILED DESCRIPTION

In the ensuing description, various specific details are illustrated aimed at enabling an in-depth understanding of the embodiments. The embodiments may be provided without one or more of the specific details, or with other methods, components, materials, etc. In other cases, known structures, materials, or operations are not shown or described in detail so that various aspects of the embodiments will not be obscured.

Reference to "an embodiment" or "one embodiment" in the framework of this description is meant to indicate that a particular configuration, structure, or characteristic described in relation to the embodiment is comprised in at least one embodiment. Hence, phrases such as "in an embodiment", "in one embodiment", or the like that may be present in various points of this description do not necessarily refer to one and the same embodiment. Moreover, particular conformations, structures, or characteristics may be combined in any adequate way in one or more embodiments.

In the following description, certain specific details are set forth in order to provide a thorough understanding of various disclosed embodiments. However, one skilled in the relevant art will recognize that embodiments may be practiced without one or more of these specific details, or with other methods, components, materials, etc. In other instances, well-known aspects of ingot processing, wafer processing, and surface analysis have not been shown or described in detail, to avoid unnecessarily obscuring descriptions of the embodiments.

Unless the context requires otherwise, throughout the specification and claims which follow, the word "comprise" and variations thereof, such as, "comprises" and "comprising" are to be construed in an open, inclusive sense, that is as "including, but not limited to." Further, the terms "first," "second," and similar indicators of sequence are to be construed as interchangeable unless the context clearly dictates otherwise.

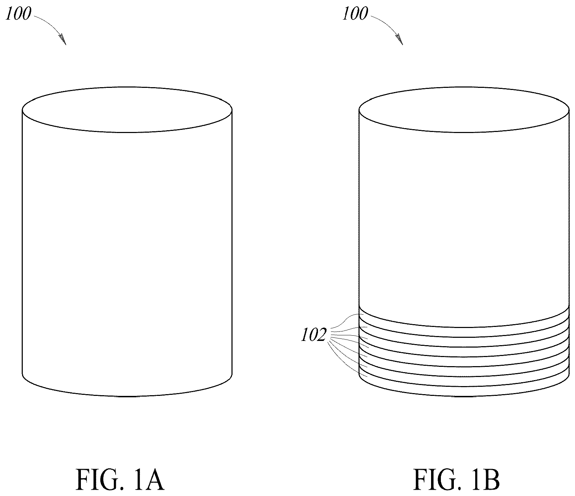

Figure 1A is an illustration of a semiconductor ingot 100, in accordance with one embodiment. The semiconductor ingot 100 includes a monocrystalline semiconductor material. As will be set forth in more detail below, semiconductor wafers will be sliced from the semiconductor ingot 100 and the semiconductor wafers will be processed to form integrated circuits.

In one embodiment, the semiconductor ingot 100 is a monocrystalline silicon carbide semiconductor ingot. In one embodiment, the wafers sliced from the ingot 100 will be utilized to form power transistors, power converters, diodes, and other electronic circuitry. While the following description focuses primarily on embodiments in which the semiconductor ingot 100 is a monocrystalline silicon carbide semiconductor ingot, other semiconductor materials can be utilized. For example, in one embodiment the semiconductor region 100 includes monocrystalline silicon, gallium nitride, or other semiconductor materials. In one embodiment, the wafers sliced from the ingot 100 are utilized to form CMOS devices including processors, microcontrollers, memory devices, or other types of devices.

In one embodiment, the ingot 100 is a cylinder. In one embodiment, the ingot 100 has a diameter of 150 mm. The wafers sliced from the ingot 100 likewise will have a diameter of 150 mm. In one embodiment, the ingot 100 has a diameter of 200 mm, 300 mm or other diameters.

It is costly in terms of time and resources to form a monocrystalline silicon carbide ingot 100. Accordingly, the ingot 100, and the wafers sliced from ingot 100 are typically very valuable. Furthermore, the wafers will undergo a large number of processing steps in order to form integrated circuits in the wafers.

It is possible that during formation of the ingot 100, various imperfections or defects will propagate within the crystalline structure of the ingot 100. One common class of defects are bulk inclusions. Bulk inclusions are voids commonly found in the crystal throughout the entire volume, at a varying number and range in sizes of few hundred nanometers to several micrometers. These bulk inclusions can originate from various growth conditions. As will be set forth in more detail below, it is possible that such defects can result in poorly functioning, or even nonfunctioning devices formed from the wafers. As will be set forth in more detail below, embodiments of the present disclosure provide a method and system to avoid processing wafers that would be likely to result in defective integrated circuits due to the presence of bulk inclusions in the wafer.

Figure 1B is an illustration of the ingot 100 of Figure 1A, with a plurality of wafers 102 sliced from the ingot 100, in accordance with one embodiment. A large number of wafers 102 are sliced from each ingot 100. The wafers 102 are subsequently processed to form integrated circuits, as described in more detail below.

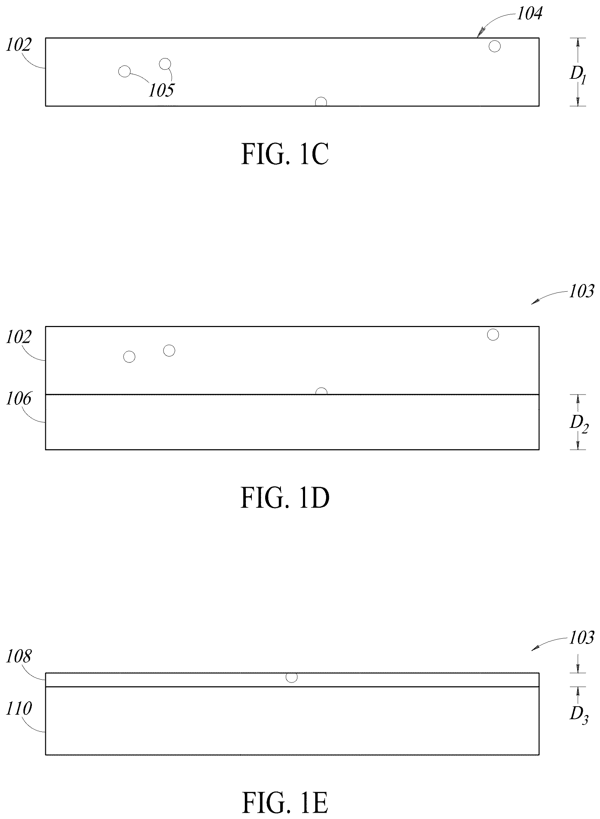

Figure 1C is a cross-sectional view of a wafer 102 of Figure 1B, in accordance with one embodiment. At the stage of processing shown in Figure 1C, the wafer 102 has a thickness dimension D1. In one embodiment, the dimension D1 is between 500 µm and 1 mm, though other dimensions can be utilized without departing from the scope of the present disclosure.

Figure 1C also illustrates defects 105 within the wafer 102. The defects 105 corresponds to the bulk inclusions described previously. In many cases, defects 105 can be problematic if they are present at the top surface of the wafer 102. In the example shown in Figure 1C the defects 105 are not at the surface 104. If subsequent epitaxial layers were grown from the surface 104 is shown in Figure 1C, it is likely that there would not be defects within the integrated circuits. However, as will be set forth in more detail below, other processes are utilized to enable generating a plurality of thinner slices from each wafer 102. Due to the reduced thickness of these thinner slices, any defects within the thinner slices are highly likely to be at the top surface, thereby creating increased potential for defective integrated circuits.

Figure 1D is a cross-sectional view of a hybrid wafer 103, in accordance with one embodiment. As described in relation to Figure 1C, bonding and slicing processes are utilized to form multiple hybrid wafers 103 from a single wafer 102. In Figure 1D, a hybrid wafer 106 has been formed by bonding the wafer 102 to a substrate 106.

In one embodiment, the substrate 106 corresponds to a lower quality semiconductor wafer sliced from a lower quality ingot. In an example in which the wafer 102 is silicon carbide, the substrate 106 can correspond to a polysilicon carbide wafer sliced from a polysilicon carbide ingot. The polysilicon carbide ingot is far less costly to manufacture than a monocrystalline silicon carbide wafer. Accordingly, utilization of a polysilicon carbide wafer as a base substrate and a monocrystalline silicon carbide wafer 102 as a surface portion of the hybrid wafer can result in reducing costs in wafer manufactured, as will be described in further detail below. Other low-cost materials can be utilized for the substrate 106 without departing from the scope of the present disclosure. In one embodiment, the substrate 106 includes other types of lower quality poly crystalline materials.

The substrate 106 has a thickness dimension D2. In one embodiment, the thickness dimension D2 is between 350 µm and 500 µm, with up to 700 µm for wafers of 300 mm diameter, though other thicknesses can be utilized without departing from the scope of the present disclosure.

Figure 1E is a cross-sectional view of the hybrid wafer 103 of Figure 1D after a slicing process has been performed, in accordance with one embodiment. The slicing process slices the wafer 102 at a location near the surface of the substrate 106. The result is that a relatively thin monocrystalline semiconductor layer 108 from the wafer 102 remains on the substrate 106. The portion of the wafer 102 sliced away from the hybrid wafer 103 can then be bonded to another relatively low-quality substrate 106 in order to form another hybrid wafer 103. This can continue in a plurality of iterations to form a plurality of hybrid wafers 103 from a single wafer 102.

In Figure 1E, the monocrystalline semiconductor layer 108 has a thickness dimension D3. In one embodiment, the thickness dimension D3 is between 200 nm and 900 nm, though other values can be utilized without departing from the scope of the present disclosure. Accordingly, the thickness of the monocrystalline semiconductor layer 108 is greatly reduced compared to the original thickness of the wafer 102.

The substantial reduction in thickness also results in an increased probability that defects within the monocrystalline semiconductor layer 108 will be present at the surface 104. Figure 1E illustrates a defect 105 at the surface of the monocrystalline semiconductor layer 108. Furthermore, due to the reduced thickness dimension D3, the defect 105 propagates from the top surface to the bottom surface of the semiconductor layer 108. For simplicity, only a single defect 105 is illustrated in Figure 1E. The defect 105 corresponds to a hole in the semiconductor layer 108.

It is possible that the presence of defects 105 in the monocrystalline semiconductor layer 108 can result in defective integrated circuits after processing. In one embodiment, an epitaxial layer is initially grown from the semiconductor layer 108 during subsequent processing steps. The presence of defects extending through the entirety of a thickness of the semiconductor layer 108 can result in a poorly formed epitaxial layer. The poorly formed epitaxial layer can further result in nonfunctioning circuit structures.

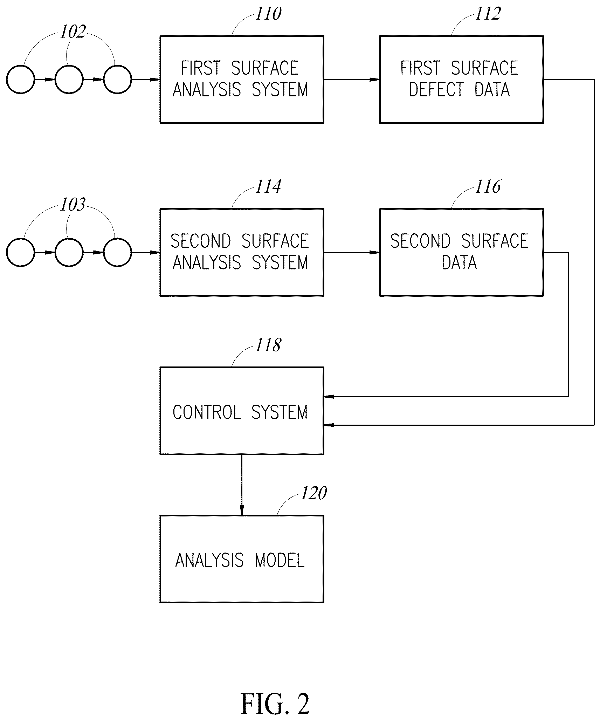

Figure 2 is a functional flow diagram of a process for generating an analysis model 120 that can be utilized to identify wafers 102 that are likely to result in problematic hybrid wafers 103 prior to formation of the hybrid wafers 103, in accordance with one embodiment. Figure 2 illustrates a plurality of monocrystalline semiconductor test wafers 102t diced from a monocrystalline semiconductor ingot as described in relation to Figures 1A-1C. Figure 2 illustrates a plurality of hybrid test wafers 103t formed from the wafers 102 substantially as described in relation to Figures 1D and 1E. The first and second wafers are referred to as test wafers and include the suffix t (102t and 103t) because these wafers will be utilized to generate an analysis model that will be used to sort subsequently formed wafers 102 prior to formation of hybrid wafers 103.

In Figure 2, after slicing the first test wafers 102t from the ingot, each of the test wafers 102t is passed to a first surface analysis system 110. The first surface analysis system 110 performs an analysis process on the top surface 104 of each first test wafer 102t. The first surface analysis system 110 generates first surface defect data 112. The first surface defect data 112 indicates the defects present at the top surface 104 of each test wafer 102t. Further details regarding the first surface analysis system 110 and the first surface defect data 112 are provided below.

In one embodiment, the first surface analysis system includes a plurality of lasers that each irradiate the surface 104 of the wafer 102. In one embodiment, multiple lasers each irradiate each point of the surface 104 of the wafer 102 from different angles and with differing polarizations. A plurality of detectors detect the reflected or refracted laser light from the multiple lasers. The entirety of the surface 104 can be irradiated by the array of lasers. The presence of defects at the surface of the wafer 102 will result in scattering of the laser light in unexpected directions. When no defects are present at a location, the laser light is reflected in the expected manner onto the sensors. In this manner, the first surface analysis system analyzes the surface 104 of the wafer 102. Other types of surface analysis systems can be utilized without departing from the scope of the present disclosure.

In one embodiment, the first surface defect data 112 includes a contrast map of the surface of the wafer 102. The surface defect data 112 can include, for each wafer 102, a map of the surface of the wafer 102 including the location of defects of various sizes. The presence of small defects at the surface of the wafer 102 can be an indication of large dislocations that would correspond to holes within thin slices of the wafer 102. In one embodiment, the first surface analysis system 110 provides a relatively low-resolution defect distribution of the wafers 102 compared to the second surface defect data 116 generated by the second surface analysis system 114, as will be described in more detail below. Further details regarding the first surface defect data 112 and how it is used to build the model 120 will be provided below.

In Figure 2, after passing each of the first test wafers 102t through the first surface analysis system 110, a plurality of second test wafers 103t (hybrid wafers) are formed from the first test wafers 102t. As described previously, each second test wafer 103t includes a thin monocrystalline semiconductor layer 108 on a lower quality substrate 106. Each thin monocrystalline semiconductor layer 108 corresponds to a thin slice of one of the first test wafers 102t. Because a plurality of second test wafers 103t are generated from each test wafer 102t, a larger number of second test wafers 103t than first test wafers are utilized to build the analysis model 120.

In one embodiment, the second wafer surface analysis system 114 includes a plurality of lasers that each irradiate the surface of the second test wafer 103t. In one embodiment, the second wafer surface analysis system 114 includes both photoluminescence inspection and confocal differential interference contrast inspection utilizing a plurality of lasers and detectors. The second wafer surface analysis system 114 generates a higher-resolution surface defect map than does the first surface analysis system 110. The second wafer surface analysis system 114 has a different configuration than the first wafer surface analysis system 110. For example, the second wafer surface analysis system 114 utilizes lasers with smaller wavelengths than the first wafer surface analysis system 110, thereby enabling the second wafer surface analysis system 114 to be more surface sensitive. Smaller wavelengths result in smaller penetration depths. The results of the second wafer surface analysis system 114 show more accurately what is on the surface of the wafer. Many principles of the first surface analysis system 110 are utilized by the second wafer surface analysis system 114.

In one embodiment, the second surface defect data 116 includes a hole density of the second test wafers 103t. The hole density includes a number of holes of a selected size per area of the second test wafer 103t. The second surface defect data 116 can include a map of holes, or other types of defects for each second test wafer 103t.

After generation of the first surface defect data 112 and the second surface defect data 116, the first and second surface defect data 112 and 116 are provided to a control system 118. The control system 118 includes one or more processors, one or more memories, and other computing resources for analyzing and processing the first surface defect data 112 and the second surface defect data 116.

The control system 118 generates an analysis model 120. The analysis model 120 includes a model that facilitates the sorting of wafers 102 into either a first group or a second group. The first group corresponds to wafers 102 that are acceptable for further processing including formation and processing of hybrid wafers 103. The second group corresponds to wafers that will either be scrapped or repurposed.

In one embodiment, once the analysis model 120 has been generated, the analysis model 120 is utilized to sort the wafers 102 based only on first surface defect data 112. In other words, each wafer 102 from an ingot 100 is passed to the first surface analysis system 110. The first surface analysis system 110 generates first surface defect data 112. The analysis model 120 sorts the wafers 102 into the first and second groups based on the first surface defect data 112. The analysis model 120 is generated based on both the first surface analysis system 110 and the second surface analysis system 114, but is utilized to sort wafers 102 based on only the first surface analysis system 110, in accordance with one embodiment.

In one embodiment, the analysis model 120 is generated by generating a cleanliness condition C from the first surface defect data 112 of a selected number of wafers 102, in accordance with the following equation: $C = \frac{1}{3} {\sum }_{j = 1}^{m} {D}_{j} where m ϵ \left\{1, 2, 3\right\}$ where m is the selected number of wafers 102 (e.g., 3 test wafers 102t in this example), and D is the count of defects (bulk inclusions, particles, etc.), with a size that is less than or equal to a selected threshold size. In one example, the selected threshold size is 300 nm, though other threshold sizes can be selected without departing from the scope of the present disclosure. In one embodiment, the defect size corresponds to the largest lateral dimension of a defect at the surface of the wafer.

In one embodiment, second surface defect data 116 includes, for each of n second test wafers 103t, a hole density H. The hole density H corresponds to the density of voids or other types of holes in the second test wafer 103t based on the second surface defect data 116. In one embodiment, the control system 118 utilizes the defect count D, the cleanliness condition C, the hole density H, and the wafer area A for N wafers to generate a defect-to-hole conversion constant K, in accordance with the following equation: $K = \frac{1}{N} {\sum }_{i = 1}^{n} \frac{\left({D}_{i}-C\right)}{{H}_{i} ∗ {A}_{i}} where m ϵ ℕ$

In one embodiment, the constant K is then utilized to generate an expected density of bulk inclusions *ρ_{BI}.* The expected density of bulk inclusions *ρ_{BI}* corresponds to a threshold value expected to give rise to a failed layer transfer. A failed layer transfer corresponds to a defective epitaxial layer grown from the semiconductor layer 108. In one embodiment, *ρ_{BI}* is given by the following equation: ${ρ}_{BI , wafer} = \frac{1}{N} {\sum }_{i = 1}^{n} \frac{\left({D}_{wafer}-\frac{1}{3}{\sum }_{j = 1}^{n} {P}_{j}\right)}{{H}_{i} ∗ {A}_{i} ∗ {A}_{wafer}} = K \frac{\left({D}_{wafer}-C\right)}{{A}_{wafer}}$

In one embodiment, the control system 118 generates a maximum defect threshold Dmax based on C, K, and *ρ_{BI}.* If a wafer 102 has a defect count D that is greater than Dmax, then it is likely that any hybrid wafers 103 formed from that wafer 102 will not be able to grow a proper epitaxial layer on top of the semiconductor layer 108. In one embodiment, the threshold value Dmax is generated based on the following equation: ${D}_{max} = \frac{{ρ}_{BI ∗ A}}{K} + C$

Accordingly, after generation of the analysis model 120, and, more particularly, the value Dmax, wafers 102 can be sorted based on the average count of defects D found in the first surface defect data 112. This is an effective and efficient way to sort wafers 102 prior to formation of the hybrid wafers 103. This results in tremendous savings of time and resources. Other types of analysis models 120 can be generated without departing from the scope of the present disclosure.

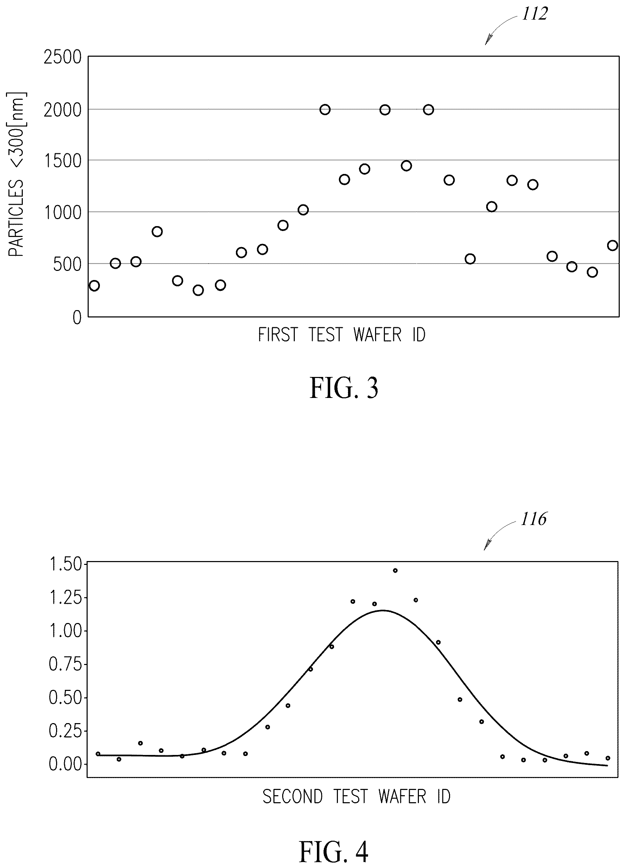

Figure 3 is a graph illustrating an aspect of the first surface defect data 112 for a plurality of first test wafers 102t, in accordance with one embodiment. More particularly, the graph of Figure 3 illustrates, for each of a plurality of test wafers 102t, the number of defects having a size less than 300 nm.

Figure 4 is a graph illustrating an aspect of the second surface defect data 116 for a plurality of second test wafers 103t, in accordance with one embodiment. More particularly, the graph of Figure 4 illustrates, for each of a plurality of second test wafers 103t, the bulk inclusions density.

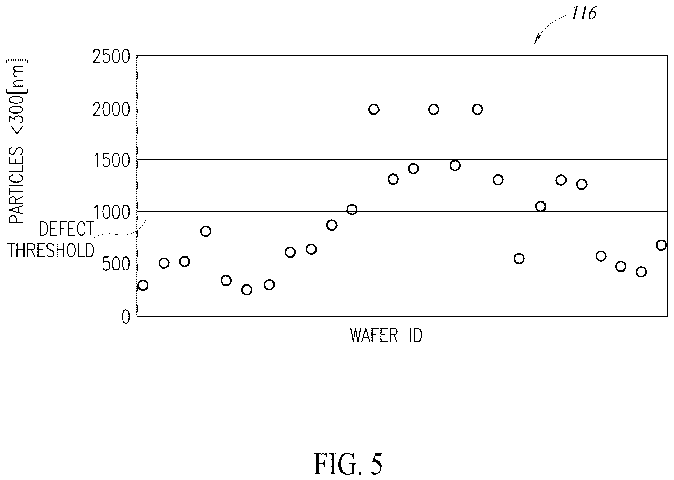

Figure 5 corresponds to the graph of Figure 3, including a defect threshold generated by the control system 118 as described in relation to Figure 2, in accordance with one embodiment. In one example, the expected density of bulk inclusions *ρ_{BI}* from the second surface defect data 116 is 0.5 cm^-2, the wafer area A is 176 cm^2, the cleanliness condition C is 150, and the defect-to-hole conversion constant K is 1/6. This results in a maximum defect threshold Dmax of 778. This value of the maximum defect threshold Dmax is shown on the graph of Figure 5. In one embodiment, the defect threshold can be utilized to sort wafers 102 into the first and second groups, as described above. In particular, wafers 102 having a defect count less than the defect count threshold are sorted into the first group and will thus be utilized to form hybrid wafers 103 and processed to form integrated circuits. The wafers 102 with defect counts higher than a defect count threshold are sorted into the second group and are either scrapped or repurposed.

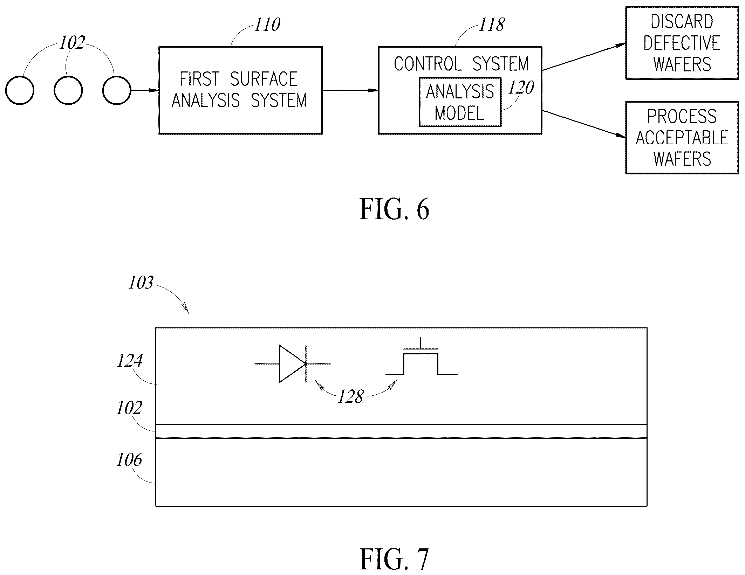

Figure 6 is a functional flow diagram of a process wafers, in accordance with one embodiment. In Figure 6, the analysis model 120 has already been generated by the control system 118 as described in relation to Figure 2. The analysis model 120 can be utilized to sort wafers 102. In Figure 6, a plurality of wafers 102 are sliced from an ingot 100. The wafers 102 are passed to the first surface analysis system 110. The first surface analysis system 110 generates surface defect data 112 for each of the wafers 102. The surface defect data is provided to the control system 118. The control system 118 applies the analysis model 120 to the first surface defect data for each wafer 102. The control system 118 sorts the wafers 102 based on the analysis model 120. In particular, at 125, wafers 102 that have a number of defects less than the defect count threshold are deemed acceptable and sent for further processing (i.e., to form hybrid wafers 103). At 126, wafers 102 that have a number of defects greater than the defect count threshold are deemed defective and sent to be discarded or repurposed.

Figure 7 is a cross-sectional view of a wafer 103 after completion of processing, in accordance with one embodiment. The second wafer 103 includes a substrate 106 and a monocrystalline semiconductor layer 108 corresponding to a portion of an acceptable wafer 102. A stack of layers 124 has been formed on the monocrystalline semiconductor layer 108. The stack of layers 124 includes one or more epitaxial semiconductor layers grown from the semiconductor layer 108. The stack of layers 124 includes dielectric layers and conductive structures formed on the epitaxial layers to produce circuit structures 128. In the example Figure 7, the circuit structures 128 include one or more diodes of power transistors. However, other circuit structures 128 can be utilized without departing from the scope of the present disclosure.

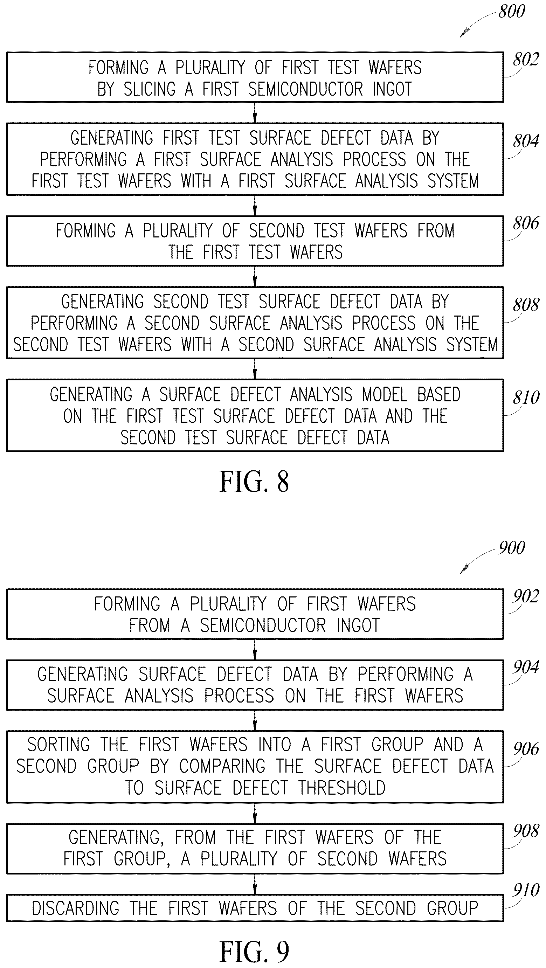

Figure 8 is a flow diagram of a method 800, in accordance with one embodiment. The method 800 can utilize systems, processes, and components described in relation to Figures 1-7. At 802, the method 800 includes forming a plurality of first test wafers by slicing a first semiconductor ingot. At 804, the method 800 includes generating first test surface defect data by performing a first surface analysis process on the first test wafers with a first surface analysis system. At 806, the method 800 includes forming a plurality of second test wafers from the first test wafers. At 808, the method 800 includes generating second test surface defect data by performing a second surface analysis process on the second test wafers with a second surface analysis system. At 810, the method 800 includes generating a surface defect analysis model based on the first test surface defect data and the second test surface defect data.

Figure 9 is a flow diagram of a method 900, in accordance with one embodiment. The method 900 can utilize systems, processes, and components described in relation to Figures 1-8. At 902, the method 900 includes forming a plurality of first wafers from a semiconductor ingot. At 904, the method 900 includes generating surface defect data by performing a surface analysis process on the first wafers. At 906, the method 900 includes sorting the first wafers into a first group and a second group by comparing the surface defect data to surface defect threshold. At 908, the method 900 includes generating, from the first wafers of the first group, a plurality of second wafers. At 910, the method 900 includes discarding the first wafers of the second group.

In one embodiment, a method includes forming a plurality of first test wafers by slicing a first semiconductor ingot and generating first test surface defect data by performing a first surface analysis process on the first test wafers with a first surface analysis system. The method includes forming a plurality of second test wafers from the first test wafers, generating second test surface defect data by performing a second surface analysis process on the second test wafers with a second surface analysis system, and generating a surface defect analysis model based on the first test surface defect data and the second test surface defect data.

In one embodiment, the surface defect analysis model includes a threshold defect count.

In one embodiment, generating the surface defect analysis model includes generating, based on the first test surface defect data, a number of surface defects for each first test wafer and a cleanliness value corresponding to an average count of surface defects for the first test wafers.

In one embodiment, the second test surface defect data includes, for each second test wafer, a hole density value indicating a density of holes per surface area of each second test wafer.

In one embodiment, generating the surface defect analysis model includes generating a defect-to-hold conversion constant based on the number of surface defects for each first test wafer, the cleanliness value, and the hole density value for each second test wafer.

In one embodiment, generating the surface defect analysis model includes generating an expected density of bulk inclusions value based on the hole density value and the cleanliness value, wherein the expected density of bulk inclusions value corresponds to a value beyond which an epitaxial layer formed on a second test wafer is expected to fail.

In one embodiment, the method includes generating the threshold defect count based on the expected density of bulk inclusions value, the hole density value, and the cleanliness value.

In one embodiment, the method includes generating surface defect data by performing the first surface analysis process on a plurality of wafers after generating the surface defect analysis model. The method includes analyzing the third surface defect data with the surface defect analysis model and sorting each third wafer into either a first group or a second group based on the third surface defect data and the surface defect analysis model.

In one embodiment, the first group corresponds to wafers with acceptable defect levels, wherein the second group corresponds to wafers with unacceptable defect levels.

In one embodiment, the third surface defect data includes, for each wafer, a surface defect count.

In one embodiment, the sorting includes comparing the defect count of each wafer to the threshold defect count.

In one embodiment, the method includes sorting each third wafer into the first group if the surface defect count is less than the threshold defect count and sorting each third wafer into the second group if the surface defect count is greater than the threshold defect count.

In one embodiment, forming each second test wafer includes bonding a first test wafer to a substrate and slicing the first test wafer near a surface of the substrate.

In one embodiment, wherein the substrate includes a polycrystalline semiconductor material.

In one embodiment, a method includes forming a plurality of first wafers from a semiconductor ingot, generating surface defect data by performing a surface analysis process on the first wafers, and sorting the first wafers into a first group and a second group by comparing the surface defect data to a surface defect threshold. The method includes generating, from the first wafers of the first group, a plurality of second wafers and discarding the first wafers of the second group.

In one embodiment, the surface defect threshold includes a threshold number of defects having a size less than a threshold size.

In one embodiment, the first wafers include monocrystalline silicon carbide and the second wafers include a layer of monocrystalline silicon carbide bonded to a substrate of polycrystalline silicon carbide.

In one embodiment, a system includes one or more memories configured to store software instructions and one or more processors configured to execute the software instructions to perform a process. The process includes receiving, for each of a plurality of first wafers, a surface defect count based on a first surface analysis process of the first wafers and comparing, for each first wafer, the surface defect count to a surface defect threshold. The process includes sorting each first wafer into a first group if the surface defect count is less than the surface defect threshold and sorting each first wafer into a second group if the surface defect count is greater than the surface defect threshold.

In one embodiment, the first group includes first wafers from a plurality of second wafers will be formed, wherein the second group includes first wafers that will be discarded.

In one embodiment, the process includes generating the surface defect threshold based on first surface defect data generated by performing the first surface analysis process on a plurality of first test wafers and second surface defect data generated by performing a second surface analysis process on second test wafers formed from the first test wafers.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A method (800), comprising:
forming (804) a plurality of first test wafers (102t) by slicing a first semiconductor ingot (100);
generating (804) first test surface defect data (112) by performing a first surface analysis process on the first test wafers (102t) with a first surface analysis system (110);
forming (806) a plurality of second test wafers (103t) from the first test wafers (102t);
generating (808) second test surface defect data (116) by performing a second surface analysis process on the second test wafers (103t) with a second surface analysis system (114); and
generating (810) a surface defect analysis model (120) based on the first test surface defect data (112) and the second test surface defect data (116).

2. The method of claim 1, wherein the surface defect analysis model (120) includes a threshold defect count (Dmax).

3. The method of claim 2, wherein generating the surface defect analysis model (120) includes generating, based on the first test surface defect data (112), a number of surface defects (D) for each first test wafer (102t) and a cleanliness value (C) corresponding to an average count of surface defects for the first test wafers (102t).

4. The method of claim 3, wherein the second test surface defect data (116) includes, for each second test wafer (103t), a hole density value (H) indicating a density of holes per surface area of each second test wafer (103t).

5. The method of claim 4, wherein generating the surface defect analysis model(120) includes generating a defect-to-hold conversion constant (K) based on the number of surface defects (D) for each first test wafer (102t), the cleanliness value (C), and the hole density value (H) for each second test wafer (103t).

6. The method of claim 5, wherein generating the surface defect analysis model (120) includes generating an expected density of bulk inclusions value (PBI) based on the hole density value (H) and the cleanliness value (C), wherein the expected density of bulk inclusions value corresponds to a value beyond which an epitaxial layer formed on a second test wafer (103t) is expected to fail.

7. The method of claim 6, comprising generating the threshold defect count (Dmax) based on the expected density of bulk inclusions value (PBI), the hole density value (H), and the cleanliness value (C).

8. The method of claim 2, comprising:
generating surface defect data (112) by performing the first surface analysis process on a plurality of wafers (102) after generating the surface defect analysis model (120);
analyzing the third surface defect data (112) with the surface defect analysis model (120); and
sorting each third wafer (102) into either a first group (125) or a second group (126) based on the third surface defect data (112) and the surface defect analysis model (120).

9. The method of claim 2, wherein the third surface defect data (112) includes, for each wafer (102), a surface defect count, wherein the sorting includes comparing the defect count (D) of each wafer (102) to the threshold defect count (Dmax).

10. The method of claim 9, comprising sorting each third wafer (102) into the first group (125) if the surface defect count (D) is less than the threshold defect count (Dmax) and sorting each third wafer (102) into the second group (126) if the surface defect count (D) is greater than the threshold defect count.

11. The method of claim 1, wherein forming each second test wafer (103t) includes bonding a first test wafer (102t) to a substrate (106) and slicing the first test wafer (102t) near a surface of the substrate (106), wherein the substrate includes in particular a polycrystalline semiconductor material.

12. A method (900), comprising:
forming (/902) a plurality of first wafers (102) from a semiconductor ingot (100);
generating (904) surface defect data (112) by performing a surface analysis process on the first wafers;
sorting (906) the first wafers into a first group (125) and a second group (126) by comparing the surface defect data (112) to a surface defect threshold (Dmax);
generating (908), from the first wafers of the first group, a plurality of second wafers (103); and
discarding (910) the first wafers of the second group.

13. The method of claim 12, wherein the surface defect threshold includes a threshold number of defects having a size less than a threshold size (Dmax).

14. The method of claim 12 or 13, wherein the first wafers (102) include monocrystalline silicon carbide and the second wafers (103) include a layer of monocrystalline silicon carbide (108) bonded to a substrate of polycrystalline silicon carbide (106).

15. A system (118), comprising:
one or more memories configured to store software instructions;
one or more processors configured to execute the software instructions to perform a process including:
receiving, for each of a plurality of first wafers (102), a surface defect count (D) based on a first surface analysis process of the first wafers;
comparing, for each first wafer (102), the surface defect count (D) to a surface defect threshold (Dmax);
sorting each first wafer into a first group (125) if the surface defect count (D) is less than the surface defect threshold (Dmax); and
sorting each first wafer (102) into a second group (126) if the surface defect count (D) is greater than the surface defect threshold (Dmax).
